# EUROPEAN PATENT APPLICATION

(11) **EP 1 840 959 A1**
(43) Date of publication of application: **03.10.2007**
(21) Application number: 07251306.2
(22) Date of filing: 27.03.2007
(51) Int. Cl.: H01L 21/768, H01L 21/285

(54) **Hybrid ionized physical vapor deposition of via and trench liners**

(30) Priority: 29.03.2006 US 786964 P; 15.02.2007 US 706502
(71) Applicant: STMicroelectronics, Inc., Carrollton, TX 75006-5039 (US)
(72) Inventor: Niu, Chengyu, The Colony Texas 75056 (US)
(74) Representative: Style, Kelda Camilla Karen

(57) **Abstract**

A hybrid ionized physical vapor deposition technique to form liner films for vias, trenches, and other structures of integrated circuits. The techniques involves depositing liner materials within a via, hole, trench, or other structure in a neutral state, using, for example, physical vapor deposition. The liner materials deposited in this step have an ionization ratio of less than ten percent, and no bias potential is applied to an underlying substrate. The technique also involves depositing liner materials in ionized form in the same via using ionized physical vapor deposition. The liner materials deposited in this step have an ionization ratio far more than ten percent, and an optional bias potential may be applied to the underlying substrate. After liner film is formed, any other suitable actions or processing steps may take place including building additional metallization and dielectric layers and vias or trenches to produce a multi-level interconnect system.

## Description

### TECHNICAL FIELD

This disclosure is generally directed to integrated circuits and more specifically to systems and methods for depositing via and trench liners.

### BACKGROUND

Electrical devices (such as transistors, resistors, capacitors, and diodes) in integrated circuits are often linked by conductive lines called interconnects. Groups or collections of interconnects (called "interconnect systems") in integrated circuits are becoming increasingly complex. Conventional interconnect systems often represent multi-level structures of metal wiring (such as aluminum, tungsten, or copper) separated by interlayer dielectric (IDL) films.

In conventional interconnect systems, the flow of electric current between different interconnect levels is realized using via structures formed in the IDL films. For example, after ILD film deposition, via holes or trenches may be formed to uncover an underlying metal layer. A liner film is deposited within each via hole or trench, and the via hole or trench is filled with conductive material. A liner film often serves as an adhesion promoter or a diffusion barrier for a subsequent metallization. The liner film may also getter any interface impurities to reduce via resistance.

There is therefore a need for improved systems and methods of depositing via and trench liners.

### SUMMARY

This disclosure generally provides a method for hybrid ionized physical vapor deposition of via and trench liners.

In one embodiment, the present disclosure provides a method of fabricating an interconnect structure. The interconnect structure includes a substrate and a via. The via is disposed in a dielectric layer and a metallization layer of the interconnect structure. The method includes depositing liner material into the via using physical vapor deposition. The method also includes depositing an ionized form of the liner material into the via using physical vapor deposition to form a liner film in the via.

In another embodiment, the present disclosure provides an interconnect structure having a substrate, a dielectric layer and a metallization layer. The interconnect structure includes a via disposed in the dielectric layer and the metallization layer and a liner film in the via. The via is formed by depositing liner material into the via using physical vapor deposition and depositing an ionized form of the liner material into the via using physical vapor deposition.

Other technical features may be readily apparent to one skilled in the art from the following figures, descriptions, and claims.

### BRIEF DESCRIPTION OF THE DRAWINGS

For a more complete understanding of this disclosure, reference is now made to the following description, taken in conjunction with the accompanying drawing, in which:

FIGURE 1 illustrates an interconnect structure formed using physical vapor deposition;

FIGURE 2 illustrates an interconnect structure formed using ionized physical vapor deposition;

FIGURE 3 illustrates an example interconnect structure formed using hybrid ionized physical vapor deposition according to one embodiment of this disclosure;

FIGURE 4 illustrates an example method for hybrid ionized physical vapor deposition of via and trench liners according to one embodiment of this disclosure; and

FIGURES 5A through 5C illustrate example test results of interconnect structures formed using different techniques according to one embodiment of this disclosure.

### DETAILED DESCRIPTION

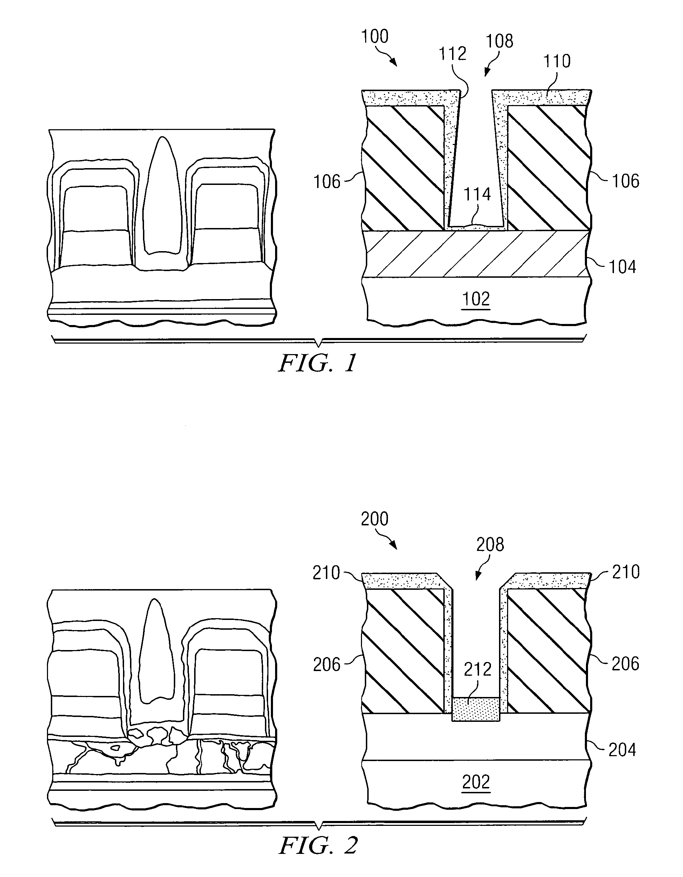

FIGURE 1 illustrates interconnect structure 100 formed using conventional physical vapor deposition techniques. As shown in FIGURE 1, interconnect structure 100 includes substrate 102 of a wafer, metallization layer 104, and dielectric layer 106. Interconnect structure 100 also includes a via hole, trench, or other high aspect ratio opening 108. Opening 108 is covered by liner film 110. Opening 108 is then typically filled with one or more conductive materials to form a via or other structure.

In the example shown in FIGURE 1, liner film 110 is formed using a physical vapor deposition technique. As a result, liner film 110 includes portions 112 that overhang into the opening 108. Portions 112 or other overhangs are generally undesirable because it obstructs or shadows the bottom corners of the opening 108, which may negatively affect the filling of opening 108 with metal during later processing steps. Liner film 110 also includes portion 114 at the bottom of opening 108, where liner film 110 is very thin or non-existent (and therefore provides poor coverage). Accordingly, FIGURE 1 generally illustrates that conventional physical vapor deposition techniques are often unsuitable for use with high aspect ratio structures and are limited in their ability to provide adequate liner films.

FIGURE 2 illustrates interconnect structure 200 formed using ionized physical vapor deposition. As shown in FIGURE 2, interconnect structure 200 generally includes substrate 202, metallization layer 204, dielectric layer 206, high aspect ratio opening 208, and liner film 210.

In the example shown in FIGURE 2, liner film 210 is formed using an ionized physical vapor deposition technique. Ionized physical vapor deposition can be used to form liner films in high aspect ratio vias, trenches, or other structures. In ionized physical vapor deposition techniques, an inductively coupled plasma (ICP) may be generated within a radio frequency (RF) powered coil placed in a cavity between a wafer and a sputtering target. Sputtered atoms entering this plasma are ionized by electron bombardment and the Penning effect as they pass through the plasma. Metal ions are then accelerated by the sheath potential between the plasma and the substrate, and the metal ions arrive at close to normal incidence to the wafer surface.

Ionized physical vapor deposition of liner film 210 may, however, result in via failure or other problems. As shown in FIGURE 2, a damaged interface 212 exists between liner film 210 and the underlying metallization layer 204 at the bottom of opening 208. Damaged interface 212 may be caused by the implantation of liner materials into the underlying metallization layer 204 (causing an absence of via liner coverage) or by the reaction of high-energy metal ions with the underlying metallization layer 204 (forming a rough interface and/or resistive compounds). Damaged interface 212 may also be caused by high-energy metal ions eroding dielectric layer 206 along the sidewalls of opening 208, causing the dielectric material to be incorporated into the interface 212 and contributing to a high via resistance.

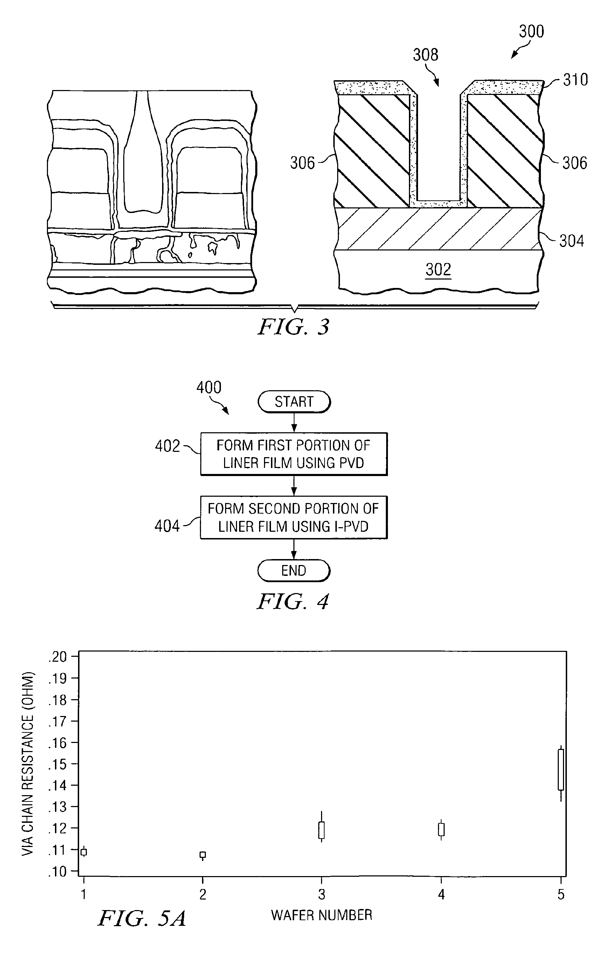

FIGURE 3 illustrates an example interconnect structure 300 formed using hybrid ionized physical vapor deposition according to one embodiment of this disclosure. Interconnect structure 300 shown in FIGURE 3 is for illustration only. Other embodiments of the interconnect structure could be used without departing from the scope of this disclosure.

As shown in FIGURE 3, interconnect structure 300 includes substrate 302. Substrate 302 could, for example, represent a semiconductor wafer having active and passive devices. Substrate 302 could represent any suitable substrate, such as a silicon substrate with active and passive devices.

Metallization layer 304 is provided over substrate 302. Metallization layer 304 is formed from one or more electrically conductive materials, such as aluminum, tungsten, copper, gold, silver, an alloy or composite, or any other material or combination of materials. Metallization layer 304 may, for example, represent a conductive line between different electrical devices (such as transistors, resistors, capacitors, or diodes) in an integrated circuit.

Dielectric layer 306 covers metallization layer 304 and substrate 302. Dielectric layer 306 may represent any suitable dielectric material or combination of materials. Dielectric layer 306 could, for example, represent one or more oxides, glass, or other dielectric material(s).

Opening 308 is formed in dielectric layer 306 down to the metallization layer 304. Opening 308 could, for example, represent a via hole or trench. Opening 308 could have any suitable size and shape. In particular embodiments, opening 308 has a high aspect ratio, meaning the ratio of height to width of opening 308 is large. Opening 308 could be formed using any suitable technique, such as a pattern and etch.

Liner film 310 is formed over dielectric layer 306 and within opening 308. Liner film 310 may, for example, serve as an adhesion promoter, a diffusion barrier, or an interface impurity getter. Liner film 310 may be formed from any suitable material or combination of materials, such as titanium, titanium nitride, tantalum, or tantalum nitride.

As described in more detail below, liner film 310 may be formed using a hybrid ionized physical vapor deposition technique according to one embodiment of the present disclosure. Using this technique, liner film 310 may have less or no overhang at the upper corners of opening 308, which may reduce or eliminate shadowing at the bottom corners of opening 308. This technique may also help to ensure that liner film 310 has better coverage along the bottom of opening 308, such as by allowing better re-sputtering or redistribution of existing liner materials inside opening 308. In addition, this technique may help to reduce or minimize damage to various regions of interconnect structure 300, such as by reducing or minimizing damage at the interface between the liner film 310 and metallization layer 304. One example technique for performing hybrid ionized physical vapor deposition is shown in FIGURE 4, which is generally described below.

After liner film 310 is deposited, any other suitable actions or processing steps may take place. For example, opening 308 could then be filled with one or more conductive materials to form a via or fill a trench. Also, additional metallization and dielectric layers and additional vias or trenches could be formed to produce a multi-level interconnect system.

Interconnect structure 300 shown in FIGURE 3 could be incorporated into or used in any suitable integrated circuit. Also, an integrated circuit could include any number of interconnect structures 300. In addition, interconnect structure 300 could be used for any suitable purpose in an integrated circuit.

Although FIGURE 3 illustrates one example of an interconnect structure 300 formed using hybrid ionized physical vapor deposition, various changes may be made to FIGURE 3. For example, each layer shown in FIGURE 3 could include any suitable material or combination of materials and be formed from one or multiple layers. Also, the particular sizes and shapes of the various layers in interconnect structure 300 are for illustration only. The various layers in the interconnect structure 300 could have any other suitable size or shape. In addition, although described as being produced over a metallization layer on a substrate, interconnect structure 300 could be formed at any suitable location or locations in an integrated circuit.

FIGURE 4 illustrates an example method 400 for hybrid ionized physical vapor deposition of via and trench liners according to one embodiment of this disclosure. Method 400 shown in FIGURE 4 is for illustration only. Other embodiments of method 400 could be used without departing from the scope of this disclosure. Also, for ease of explanation, the method 400 is described with respect to interconnect structure 300 of FIGURE 3. Method 400 could be used to form liners in any other suitable integrated circuit.

As generally shown in FIGURE 4, a hybrid ionized physical vapor deposition technique may be used to form liner film 310 for vias, trenches, and other structures of integrated circuits. In this example, liner materials are deposited into an opening for a via, trench, or other structure using physical vapor deposition at step 402. This may include, for example, depositing liner materials having a neutral state into opening 308. In particular embodiments, the liner materials are deposited with an ionization ratio of less than ten percent, and no bias potential is applied to the underlying substrate 302. This may help to ensure that the liner materials arrive at metallization layer 304 with relatively low energy, which may help to prevent an uncontrolled reaction between the liner materials and the surrounding materials or implantation of the liner materials into metallization layer 304. This step results in the creation of a thin protective film deposited over dielectric layer 306 and within opening 308. The thin protective film could, for example, have the same characteristics as liner film 108 shown in FIGURE 1 (have overhang and provide poor coverage at the bottom of the opening).

Method 400 then continues by depositing additional liner materials using ionized physical vapor deposition at step 404. This may include, for example, depositing liner materials in ionized form into opening 308. In particular embodiments, the liner materials (such as higher energy metal ions) are deposited with an ionization ratio far more than ten percent, and an optional bias potential may be applied to substrate 302 to attract the ions so they arrive at the substrate at close to normal incidence.

Because higher energy metal ions arrive at the substrate surface at close to normal incidence, these metal ions may effectively cover the bottom of opening 308. In particular embodiments, the re-sputtering of high-energy metal ions redistributes the liner material at the top corners of opening 308, thereby helping to prevent overhang formation. The re-sputtering of the high-energy metal ions can also redistribute the liner materials at the bottom of opening 308, thereby helping to improve the coverage of liner film. The resulting liner film after step 404 could represent liner film 308 shown in FIGURE 3.

The thin protective film formed during step 402 may serve as a shield during the more aggressive deposition of the remaining liner materials during step 404. The thin protective film formed during step 402 may provide one or multiple types of protection. For example, it may help to reduce or minimize implantation of the high-energy ions into the underlying layers or substrate. It may also help to reduce or prevent the direct contact of high-energy ions with the underlying metallization layer. In addition, it may help to reduce or prevent the high-energy ions from sputtering the sidewall dielectric material, thereby reducing or preventing the dielectric material from being incorporated into the interface at the bottom of opening 308.

The following represents additional details regarding a particular implementation of method 400. These details are for illustration and explanation only. Other embodiments of method 400 could operate in a different manner without departing from the scope of this disclosure.

During step 402 of method 400, the pressure in a sputtering chamber could be lower than during step 404, such as at 5 mTorr or less. This may help to reduce or minimize the collision of liner vapor species with sputtering gas, thereby improving the deposition rate and via/trench bottom coverage. Also, during step 402, there could be a larger distance between the substrate and the sputter target, which may help to simulate the Long-Throw-Sputtering technique for better via/trench bottom coverage. Better via/trench bottom coverage may help to improve the protection effects as described above.

During step 404, the substrate bias may be regulated stepwise toward the more negative direction (instead of setting the negative bias throughout step 404). This may allow the energy of the incoming ions to ramp up as the liner film grows. This procedure may result in a via/trench liner layer with a good coverage profile, a consistent low via resistance, and minimal damage to the via interface.

Steps 402 and 404 could be performed in separate physical vapor deposition chambers with the same or different liner/barrier materials, or both steps could be performed in the same chamber with the same or different liner/barrier materials. Using the same chamber with the same liner/barrier materials may help to reduce or minimize the cost of implementing this technique. This technique can also be implemented in commercially available processing equipment, such as the ENDURA systems with IMP (ionized metal plasma) chambers by APPLIED MATERIALS, INC.

Although FIGURE 4 illustrates one example of method 400 for hybrid ionized physical vapor deposition of via and trench liners, various changes may be made to FIGURE 4. For example, the thin protective film formed during step 402 could be formed using any other suitable technique. Also, while described as being used to form via or trench liners, method 400 could be used to form liners for any other integrated circuit structure.

FIGURES 5A through 5C illustrate example test results of interconnect structures formed using different techniques according to one embodiment of this disclosure. The test results shown in FIGURES 5A through 5C are for illustration only.

FIGURE 5A represents test results for parametrical testing of via chain resistance. The horizontal axis of the chart in FIGURE 5A represents individual wafers, and the vertical axis of the chart represents the via chain resistance within the wafers. Wafer 1 includes titanium liner films produced using physical vapor deposition. Wafer 2 includes titanium liner films produced using hybrid ionized physical vapor deposition (wafer biased with AC power at 200W). Wafer 3 includes titanium liner films produced using hybrid ionized physical vapor deposition (wafer biased with AC power at 400W). Wafer 4 includes titanium liner films produced using ionized physical vapor deposition (wafer biased with AC power at 200W). Wafer 5 includes titanium liner films produced using ionized physical vapor deposition (wafer biased with AC power at 400W) .

As shown in FIGURE 5A, wafers 2 and 3 (formed using hybrid ionized physical vapor deposition) show less via chain resistance compared to corresponding wafers 4 and 5 (formed using ionized physical vapor deposition). Wafer 2 also shows less via chain resistance compared to wafer 1 (formed using physical vapor deposition).

Wafers 1 through 5 in FIGURE 5A use large geometry via structures. For smaller geometries, hybrid ionized physical vapor deposition could further distinguish from physical vapor deposition or ionized physical vapor deposition by giving lower or the lowest via resistance.

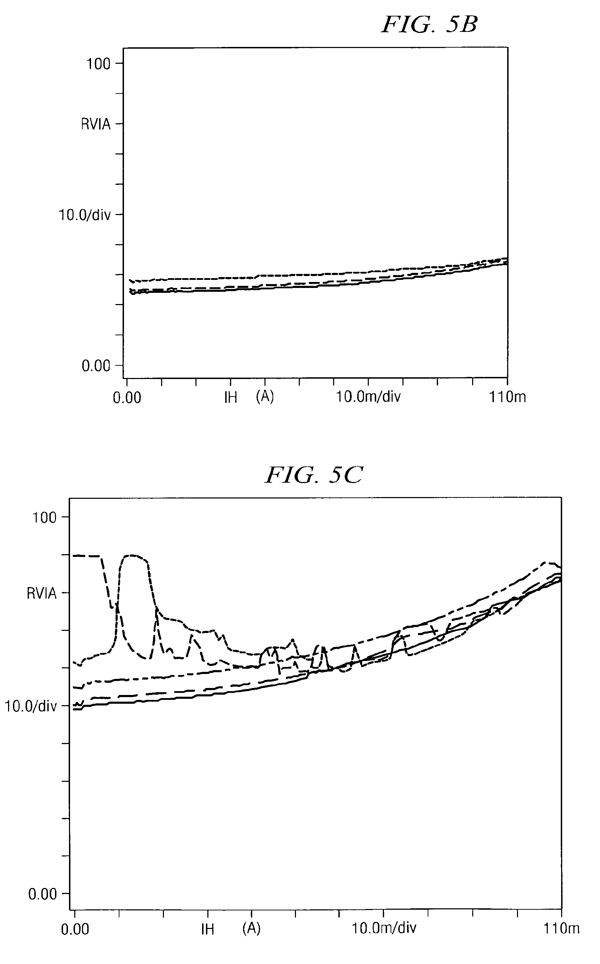

As shown in FIGURE 5B, a 400 Ångstrom titanium liner film is produced using hybrid ionized physical vapor deposition (150 Ångstrom thickness from step 402 and 250 Ångstrom thickness from step 404). This liner film is adequate to provide continuous coverage and to consume any impurities at the via interface, resulting in a low and consistent via resistance.

Compare this with FIGURE 5C, which illustrates a 400 Ångstrom titanium liner film produced using pure physical vapor deposition. This liner film is inadequate to form a good via interface, resulting in a high and inconsistent via resistance. To achieve the same via resistance as the liner film from FIGURE 5B, a titanium liner film formed using standard physical vapor deposition would be 1,000 Ångstroms thick.

Although FIGURES 5A through 5C illustrate examples of test results of interconnect structures formed using different techniques, various changes may be made to FIGURES 5A through 5C. For example, other or additional test results with the same or different interconnect structures could be obtained.

It may be advantageous to set forth definitions of certain words and phrases used throughout this patent document. The terms "include" and "comprise," as well as derivatives thereof, mean inclusion without limitation. The term "or" is inclusive, meaning and/or. The phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like.

While this disclosure has described certain embodiments and generally associated methods, alterations and permutations of these embodiments and methods have been set forth by implication and will be apparent to those skilled in the art. Accordingly, the above description of example embodiments does not define or constrain this disclosure. Other changes, substitutions, and alterations are also possible without departing from the spirit and scope of this disclosure, as defined by the following claims.

## Claims

1. A method of fabricating interconnect structure having a substrate and a via, the via disposed in a dielectric layer and a metallization layer of the interconnect structure, the method comprising:
depositing liner material into the via using physical vapor deposition; and
depositing an ionized form of the liner material into the via using physical vapor deposition to form a liner film in the via.

2. The method according to Claim 1 further comprising:
applying a bias potential to the substrate.

3. The method according to Claim 1, wherein the liner material has an ionization ratio less than 10%.

4. The method according to Claim 1, wherein the ionized form of the liner material comprises an ionization ratio of more than 10%.

5. The method according to Claim 1, wherein the ionized form of the liner material is deposited on a bottom surface of the via.

6. The method according to Claim 1, wherein the ionized form of the liner material redistributes the liner material at the top of the via to prevent overhang formation.

7. The method according to Claim 1, wherein the ionized form of the liner material is deposited at a normal incidence relative to the substrate.

8. The method according to Claim 1, wherein ambient pressure is lower during the step of depositing the liner material in a neutral state than during the step of depositing the ionized form of liner material.

9. The method according to Claim 1, wherein the via comprises a high aspect ratio.

10. The method according to Claim 1 further comprising:
disposing on the liner film at least one of: a second liner film, a second metallization layer, a second dielectric layer, and a second via.

11. An interconnect structure having a substrate, a dielectric layer and a metallization layer, the interconnect structure comprising:
a via disposed in the dielectric layer and the metallization layer; and
a liner film in the via formed by depositing liner material into the via using physical vapor deposition and depositing an ionized form of the liner material into the via using physical vapor deposition.

12. The interconnect structure according to Claim 11, wherein the via comprises a high aspect ratio.

13. The interconnect structure according to Claim 11 further comprises at least one of: a second liner film layer, a second metallization layer, a second dielectric layer, and a second via, formed on the via.

14. For use in integrated circuits, a method of fabricating a via liner, the method comprising:
depositing liner material into a via using physical vapor deposition, wherein the via is disposed in a dielectric layer and a metallization layer; and
depositing an ionized form of the liner material into the via using physical vapor deposition to form a liner film in the via.

15. The method according to Claim 14 further comprising:
applying a bias potential to the substrate.

16. The method according to Claim 14, wherein the liner material has an ionization ratio less than 10%, and wherein the ionized form of the liner material has an ionization ratio of more than 10%.

17. The method according to Claim 14, wherein the ionized form of the liner material is deposited on a bottom surface of the via.

18. The method according to Claim 14, wherein the ionized form of the liner material redistributes the liner material at the top of the via to prevent overhang formation.

19. The method according to Claim 14, wherein the ionized form of the liner material is deposited at a normal incidence relative to a substrate of the integrated circuit.

20. The method according to Claim 14, wherein the via comprises a high aspect ratio.
